# EUROPEAN PATENT SPECIFICATION

(11) **EP 1 111 472 B1**
(45) Date of publication and mention of the grant of the patent: **07.03.2007**
(21) Application number: 00311469.1
(22) Date of filing: 20.12.2000
(51) Int. Cl.: G03F 9/00, G03F 7/20

(54) **Lithographic apparatus with a position detection system**
Lithographischer Apparat mit einem System zur Positionsdetektion
Appareil lithographique avec un système de détection de position

(30) Priority: 22.12.1999 EP 99310407
(43) Date of publication of application: 27.06.2001
(73) Proprietor: ASML Netherlands B.V., 5504 DR Veldhoven (NL)
(72) Inventor: Castenmiller, Thomas Josephus Maria, 5616 BR Eindhoven (NL); Ariens, Andreas Bernardus Gerardus, 3527 WE Utrecht (NL); Hoeks, Martinus Hendricus Hendricus, 5694 SL Breugel (NL); Vogelsang, Patrick David, 5506 CW Veldhoven (NL); Loopstra, Erik Roelof, 5591 PJ Heeze (NL); Kwan, Yim Bun Patrick, 73431 Aalen (DE)
(74) Representative: Leeming, John Gerard

(56) References cited:
- GB-A- 2 162 942
- GB-A- 2 297 875
- US-A- 4 676 649

## Description

The present invention relates to the use of the position detection system in lithographic projection apparatus comprising:
an illumination system for supplying a projection beam of radiation;
a first object table for holding patterning means capable of patterning the projection beam according to a desired pattern;
a second object table for holding a substrate;
a projection system for imaging the patterned beam onto a target portion of the substrate; and
a reference frame.

The term "patterning means" should be broadly interpreted as referring to means that can be used to endow an incoming radiation beam with a patterned cross-section, corresponding to a pattern that is to be created in a target portion of the substrate; the term "light valve" has also been used in this context. Generally, the said pattern will correspond to a particular functional layer in a device being created in the target portion, such as an integrated circuit or other device (see below). Examples of such patterning means include:
- A mask held by said first object table. The concept of a mask is well known in lithography, and its includes mask types such as binary, alternating phase-shift, and attenuated phase-shift, as well as various hybrid mask types. Placement of such a mask in the projection beam causes selective transmission (in the case of a transmissive mask) or reflection (in the case of a reflective mask) of the radiation impinging on the mask, according to the pattern on the mask. The first object table ensures that the mask can be held at a desired position in the incoming projection beam, and that it can be moved relative to the beam if so desired.
- A programmable mirror array held by a structure, which is referred to as first object table. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. The required matrix addressing can be performed using suitable electronic means. More information on such mirror arrays can be gleaned, for example, from United States Patents US 5,296,891 and US 5,523,193.
- A programmable LCD array held by a structure, which is referred to as first object table. An example of such a construction is given in United States Patent US 5,229,872.
For purposes of simplicity, the rest of this text may, at certain locations, specifically direct itself to examples involving a mask; however, the general principles discussed in such instances should be seen in the broader context of the patterning means as hereabove set forth.

The projection system may hereinafter be referred to as the "lens"; however, this term should be broadly interpreted as encompassing various types of projection system, including refractive optics, reflective optics, and catadioptric systems, for example. The illumination system may also include components operating according to any of these design types for directing, shaping or controlling the projection beam of radiation, and such components may also be referred to below, collectively or singularly, as a "lens". In addition, the first and second object tables may be referred to as the "mask table" and the "substrate table", respectively.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In general, apparatus of this type contained a single first object (mask) table and a single second object (substrate) table. However, machines are becoming available in which there are at least two independently movable substrate tables; see, for example, the multi-stage apparatus described in US 5,969,441 and US Serial No. 09/180,011, filed 27 February, 1998 (WO 98/40791). The basic operating principle behind such a multi-stage apparatus is that, while a first substrate table is underneath the projection system so as to allow exposure of a first substrate located on that table, a second substrate table can run to a loading position, discharge an exposed substrate, pick up a new substrate, perform some initial metrology steps on the new substrate, and then stand by to transfer this new substrate to the exposure position underneath the projection system as soon as exposure of the first substrate is completed, whence the cycle repeats itself; in this manner, it is possible to achieve a substantially increased machine throughout, which in turn improves the cost of ownership of the machine.

In a lithographic apparatus, the size of features that can be imaged onto the substrate is limited by the wavelength of the projection radiation. To produce integrated circuits with a higher density of devices and hence higher operating speeds, it is desirable to be able to image smaller features. Whilst most current lithographic projection apparatus employ ultraviolet light generated by mercury lamps or excimer lasers, it has been proposed to use higher frequency (energy) radiation, e.g. EUV or X-rays, or particle beams, e.g. electrons or ions, as the projection radiation in lithographic apparatus.

Whatever the type of lithographic apparatus it is necessary to determine accurately the position of moveable parts, such as the object tables, at any given time. Conventionally this is done using incremental sensors, such as encoders or interferometers, that is sensors which measure change in position rather than position absolutely. It is therefore necessary to provide an additional zero reference sensor, which detects when the moveable object is at the reference or zero position, to provide a basis from which the incremental position measurements can he used to calculate an absolute position. Such zero reference systems can often offer a repeatability of 1 µm or better.

In a substrate or mask positioning system it is often desirable to be able to position the mask or substrate in all 6 degrees of freedom (DOF). Six zero reference systems and six incremental positioning systems are therefore coupled together in a kinematic chain which can result in cumulative repeatability errors which are unacceptably high. Furthermore, the zero reference of the holder is often referenced to a vibration-isolated reference frame, onto which only the most critical metrology components are mounted. Zero references of encoder systems for coarse positioning do not fit into this category and so are mounted on separate structures, the position of which remains undefined at micrometer level relative to the isolated reference frame.

US 4,676,649 discloses an interferometer system using plane mirrors mounted on moveable objects and fringe counters.

GB 2,297,87 discloses a distance measurement device in which an astigmatic liquid beam is to be measured. The shape of the reflected beam on a detector is indicative of the distance of the object.

An object of the present invention is to provide a referencing system which allows repeatable referencing, preferably to sub-micrometer accuracy, of a moveable object relative to a reference frame. Ideally the system should provide the ability to reference the moveable object in six degrees of freedom simultaneously.

According to the present invention there is provided a lithographic projection apparatus according to claim 1.

The above described position detection device can measure the position of the object table in two degrees of freedom; to detect its position in six degrees of freedom, three such position detection devices having mutually different (i.e. not parallel), preferably substantially orthogonal, orientations may be provided in the lithographic projection apparatus.

The radiation source is preferably a source of collimated radiation and may comprise a monochromatic light source such as an LED or laser diode mounted on the sensor housing or away from the reference frame and with an optical fiber to bring light emitted by said light source to beam directing optics mounted on said reference frame. This latter arrangement has the advantage of high pointing stability of the collimated light beam as well as removing a potential heat source from the reference frame, which is very sensitive to temperature fluctuations.

The two-dimensional position detector may be a two-dimensional PSD (position sensing detector), a CCD camera, a four quadrant photo-detector or any suitable two-dimensional detector array which can provide an output signal in each of two orthogonal directions as a function of the position of the reflected light beam on the detector (array). The resolution of a CCD camera used in the invention may be enhanced by sub-pixel interpolation.

According to a further aspect of the invention there is provided a method of manufacturing a device using a lithographic projection apparatus according to claim 11.

In a manufacturing process using a lithographic projection apparatus according to the invention a pattern in a mask is imaged onto a substrate which is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation or particle flux, including, but not limited to, ultraviolet (UV) radiation (e.g. at a wavelength of 365nm, 248 nm, 193 nm, 157nm or 126nm), extreme ultraviolet (EUV) radiation, X-rays, electrons and ions.

The present invention will be described below with reference to exemplary embodiments and the accompanying schematic drawings, in which:
Figure 1 depicts a lithographic projection apparatus according to a first embodiment of the invention;
Figure 2 is a plan view of a position detecting system according to the invention;
Figure 3 is a partial cross-sectional view of the position detection system of Figure 2;
Figure 4 is a cross-scctional view of a retro-reflector useable in the invention; and
Figure 5 is a cross-sectional view of an alternative retro-reflector useable in the invention.

In the drawings, like reference numerals indicate like parts.

### Embodiment 1

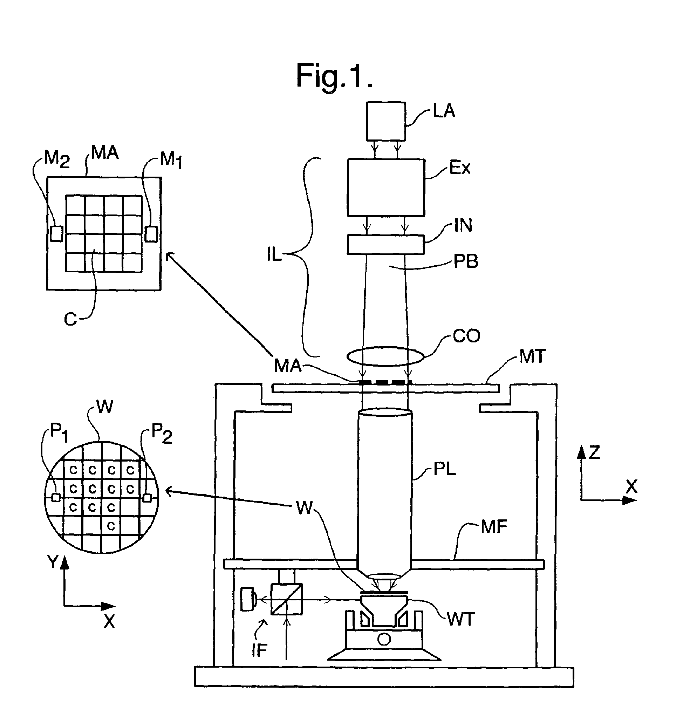

Figure 1 schematically depicts a lithographic projection apparatus according to the invention. The apparatus comprises:
- a radiation system LA, IL for supplying a projection beam PB of radiation (e.g. UV or EUV radiation);
- a first object table (mask table) MT provided with a mask holder for holding a mask MA (e.g. a reticle), and connected to first positioning means for accurately positioning the mask with respect to item PL;
- a second object table (substrate table) WT provided with a substrate holder for holding a substrate W (e.g. a resist-coated silicon wafer), and connected to second positioning means for accurately positioning the substrate with respect to item PL;
- a projection system ("lens") PL (e.g. a refractive or catadioptric system, a mirror group or an array of field deflectors) for imaging an irradiated portion of the mask MA onto a target portion C of the substrate W.
   As here depicted, the apparatus is of a transmissive type (i.e. has a transmissive mask). However, in general, it may also be of a reflective type, for example.

In the example depicted here, the radiation system comprises a source LA (e.g. a Hg lamp, excimer laser, a laser-produced or discharge plasma source, an undulator provided around the path of an electron beam in a storage ring or synchrotron, or an electron or ion beam source) which produces a beam of radiation. This beam is passed along various optical components comprised in the illumination system II., - e.g. beam shaping optics Ex, an integrator IN and a condenser CO -so that the resultant beam PB has a desired shape and intensity distribution.

The beam PB subsequently intercepts the mask MA which is held in a mask holder on a mask table MT. Having passed through the mask MA, the beam PB passes through the lens PL, which focuses the beam PB onto a target portion C of the substrate W. With the aid of the interferometric displacement measuring means IF, the substrate table WT can be moved accurately by the second positioning means, e.g. so as to position different target portions C in the path of the beam PB. Similarly, the first positioning means and interferometric displacement measuring means can be used to accurately position the mask MA with respect to the path of the beam PB, e.g. after mechanical retrieval of the mask MA from a mask library. In general, movement of the object tables MT, WT will be realized with the aid of a long stroke module (course positioning) and a short stroke module (fine positioning), which are not explicitly depicted in Figure 1.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the x direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

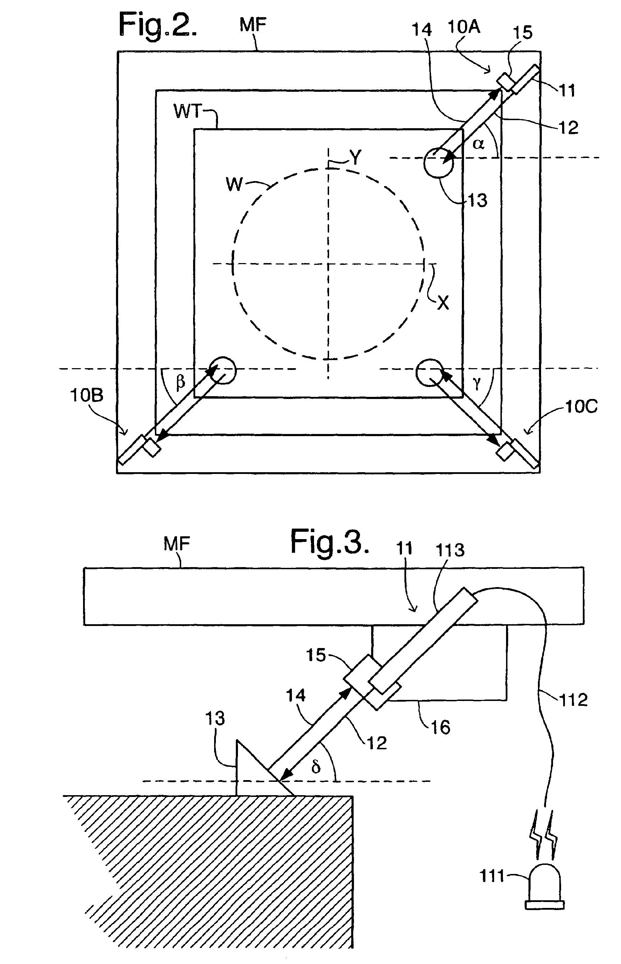

Figure 2 shows in plan an embodiment of the present invention used in conjunction with the substrate (wafer) table WT. It will be appreciated that the present invention can also be used with a mask (reticle) table. The wafer W and reference X & Y-axes are shown in phantom. The Z-axis is normal to the X and Y-axes. The position detection system according to the invention comprises three similar position detection apparatus 10A, 10B, 10C. Each position detection apparatus comprises a radiation source 11 which emits an incident beam 12 of collimated radiation towards a retro-reflector 13, that is a reflector which reflects the incident light onto a return path that is parallel to but displaced from the incident light path. The displacement of the return beam 14, in two dimensions, is a function of the relative position of the radiation source and the reflector in a plane normal to the incident beam 12. The retro-reflector 13 may, for example, be constructed from three mutually perpendicular plane reflectors meeting at a single corner, a so-called "corner cube". The reflectors may be formed by providing a mirror coating on three external faces of a corner (notionally) cut from a transmissive cube. The return beam 14 impinges on a two-dimensional radiation detector 15.

The radiation source 11 and radiation detector 15 are mounted adjacent to one another and on the isolated reference or metrology frame MF of the lithographic apparatus in a highly stable manner. Conveniently, the radiation source 11 and radiation detector 15 may be mounted to each other or to a single bracket 16, shown in Figure 3. The housing(s) and/or mounting bracket(s) of the position detector 15 and radiation source 11 are preferably made of a material with very low thermal coefficient of expansion, such as Zerodur (RTM) or Invar, for high thermal stability. The isolated reference or metrology frame MF may also be made of such a material. The retro-reflector 13 is mounted on the wafer table WT at a convenient location, e.g. near one corner.

The two-dimensional position detector 15 may be a two-dimensional PSD (position sensing detector), a CCD camera, a four quadrant photo-detector or any suitable two-dimensional detector array and is mounted with its sensing plane substantially perpendicular to the incident and reflected beams 12, 14.

The positions of the position detection apparatus 10A, 10B, 10C and their orientations, i.e. angles α, β, γ, are selected to provide the highest possible balanced positional sensitivity in all 6 degrees of freedom. In a specific application of the invention, the position and orientations of the position detection apparatus will be determined by factors such as the shape of the substrate table and reference frame as well as the differing sensitivities of the lithographic apparatus to positional, pitch, roll and yaw errors.

Figure 3 is a partial cross-sectional view of one position detection apparatus 10. As can there be seen the radiation source 11 and radiation detector 15 are mounted via bracket 16 to the metrology frame MF at such a position that the incident and return beams 12, 14 are inclined at an angle δ to the X-Y plane, to which the wafer W is substantially parallel. Angle δ is preferably substantially 45E so that horizontal and vertical displacements of the reflector 13 relative to the incident light beam 12 of equal magnitude result in equal displacement of the return light beam 14 on the radiation detector 15.

As shown in Figure 3, the radiation source 11 is formed of a LED or laser diode 111 or a similar monochromatic light source for emitting light into a single mode optical fiber 112 which leads that light to collimating optics 113 mounted on the metrology frame MF. In this way the light source 111 can be placed away from the metrology frame MF and thermally isolated from it. The removal of the light source from the detector housing also leads to much higher pointing stability of the collimated beam with respect to the sensor/detector.

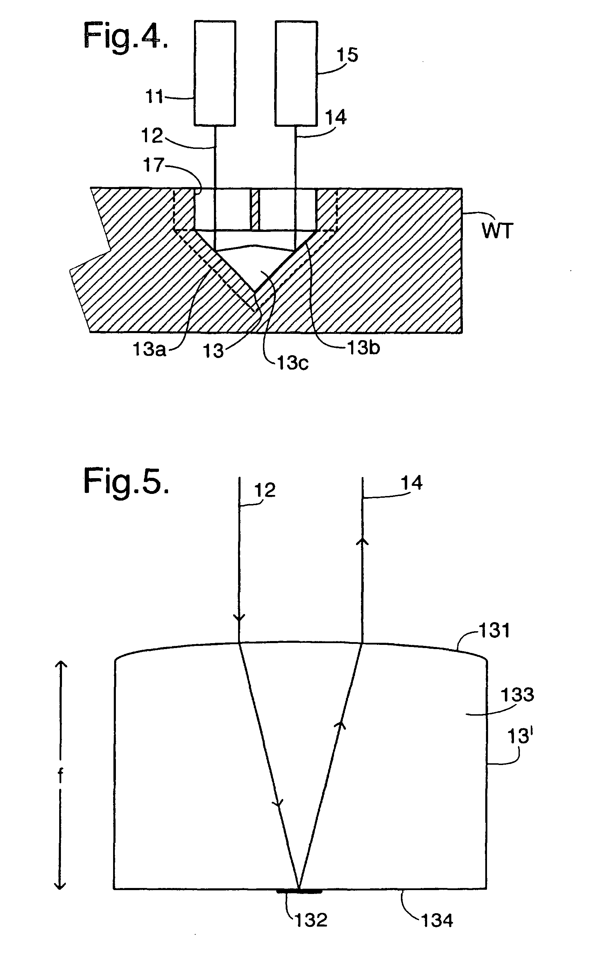

Figure 4 shows a possible arrangement of a corner cube reflector 13 inset into the substrate table WT. In this case, the light source 11 directs the incident beam 12 into corner cube reflector 13 via aperture 17. The incident beam 12 is normal to the upper surface of the substrate table WT and is reflected by the three faces 13a, 13b, 13c of the corner cube reflector 13 so that the return beam 14 is on a parallel path to detector 15. In this arrangement, the position detection apparatus detects displacement in directions parallel to the upper surface of the substrate table WT.

An alternative form of retro-reflector 13N known as a cat's-eye, is shown in Figure 5. This is useable in place of the corner cube retro-reflector 13. The cat's-eye 13N comprises a lens 131 and a mirror 132 placed at a distance for the lens 131 equal to its focal length, f. Conveniently, the lens 131 is formed in the carved front surface of a single transparent body 133 which has a plane rear surface that is selectively silvered to form mirror 132.

The three position detection devices of the invention, forming a position sensing system, provide six signals dependent on the position and orientation of the wafer table WT. The system can be used in two modes:
- as a zero-seeking system; the substrate holder is moved until all three detectors give their zero output in all 6 degrees of freedom;
- as a position measurement system; the sensor signals are transformed by an appropriate electronic or micro-processor based control systems (not shown) to six degree of freedom positioning information relative to the isolated reference frame as required by any servo or other control devices. This can be done by sampling the sensors simultaneously or in sequence.

Ideally, the positions of the radiation source/detector units on the metrology (reference) frame and the reflectors on the table are such that the table can be moved to a position where zero outputs are given for all six degrees of freedom simultaneously. (It should be noted though that the "zero" position need not be the position at which all detectors give their zero or mid range outputs; any repeatable and unique combination of output signals from the three 2-dimensional detectors can be defined as the zero position.) In other words, the capture zones of all the detection apparatus 10A, 10B, 10C should overlap. However, it may not always be possible because of the requirements of other components of the device to arrange this. In that case, the table may be moved between the capture zones of each of apparatus 10A, 10B, 10C and position signals from the incremental detector indicating the movement of the table between specific positions as indicated by the reference detection apparatus 10A, 10B, 10C used to determine the zero reference position.

It should also be noted that the referencing process may be either static, or dynamic. In a static process, the fable is moved to the reference position(s) and held stationary whilst the necessary measurements are made. In a dynamic process, which depends on the sampling frequency of the various sensors being high enough, the table may simply be moved through or near the reference position(s) and referencing of the system can be calculated from coincident measurements from the absolute and incremental reference systems. If the table does not actually pass through the reference position(s), or if samples of the measurement systems do not coincide with that passage, the measurements taken may be extrapolated or interpolated as required.

The present invention has been illustrated when used to detect the position of the substrate (wafer) table of a lithographic apparatus. It will readily be appreciated that the invention can also be used to detect the position of a mask (reticle) table in a lithographic apparatus.

A significant advantage of the position detection signal of the present invention is that there is no residual force between the metrology (reference) frame and the wafer table, as there is in the case of inductive, magnetic or capacitive sensors. This is important as the reference or metrology frame is isolated in 6 degrees of freedom with extremely low Eigenfrequencies for maximum stability. Any disturbance forces, that might be transmitted to the frame by sensors that do involve a force coupling, would result in vibrations that would take a very long time to stabilize.

A second advantage derives from the use of collimated light. This means that the sensitivity of the sensor is substantially independent of working distance, allowing greater flexibility in the layout of the reference frame, sensor modules and object table.

Whilst we have described above a specific embodiment of the invention it will be appreciated that the invention may be practiced otherwise than described. In particular, the invention may be used to zero reference a metrology system for detecting the position of either a substrate (wafer) table or a mask (reticle) table in a lithographic apparatus. Further, in a lithographic apparatus with multiple (substrate or mask) tables and/or multiple working zones (e.g. exposure and measurement or characterization zones), multiple systems may be provided with the static parts (radiation source and detector) provided in or adjacent each working zone and reflectors provided on each table. The different sets of radiation source and detector may operate in conjunction with reflectors on any table that can be positioned within their areas of operation. The description is not intended to limit the invention which is defined by the claims.

## Claims

1. A lithographic projection apparatus comprising:
an illumination system (12) for supplying a projection beam of radiation;
a first object table (MT) for holding patterning means capable of patterning the projection beam according to a desired pattern;
a second object table (WT) for holding a substrate;
a projection system (PL) for imaging irradiated portions of the mask onto target portions of the substrate;
a reference frame (MF); and
a position detection device comprising:
a radiation source (11) mounted on said reference frame (MF);
a radiation detector (15) mounted in a fixed position on said reference frame (MF); and
a retro-reflector (13) mounted on one of said object tables (MT,WT) that is moveable relative to said reference frame (MF) arranged to reflect radiation emitted by said radiation source (11) toward said radiation detector (15); **characterized in that**: said radiation detector (15) is a two-dimensional radiation detector arranged to provide an output signal in each of two orthogonal directions as a function of the position of the reflected light beam on the detector.

2. Apparatus according to claim 1 wherein said radiation source (11) is a source of collimated radiation.

3. Apparatus according to claim 1 or 2 wherein said radiation source (11) is a source of monochromatic radiation.

4. Apparatus according to any one of the preceding claims wherein said radiation source (11) comprises a light source (III) mountable away from the reference frame (MF), beam directing optics (113) mounted on said reference frame and an optical fiber (112) to couple said light source to said beam directing optics.

5. Apparatus according to any one of the preceding claims wherein said radiation source (11) comprises a laser diode, or an LED as a light source.

6. Apparatus according to any one of the preceding claims wherein said two-dimensional position detector (15) is a two-dimensional PSD, or a CCD camera, or a four quadrant photo-detector.

7. Apparatus according to any one of the preceding claims wherein said retro-reflector (13) comprises a trapezoid form of a material transparent to said radiation and having three mutually perpendicular surfaces meeting at a corner, said three surfaces being provided with a reflective coating.

8. Apparatus according to any one of claims 1 to 6 wherein said retro-reflector (13) comprises a convergent lens and a reflective surface, said reflective surface being spaced a distance from said lens equal to the focal length of said lens.

9. Apparatus according to any one of the preceding claims comprising three position detection devices as therein defined.

10. Apparatus according to any one of the preceding claims further comprising an incremental position sensing device for detecting the position of said moveable object table in a detection range wider than that of said position detection device and means for combining output signals from said incremental position sensing device and said position detector to determine an absolute position of said object table in said detection range.

11. A method of manufacturing a device using a lithographic projection apparatus comprising:
an illumination system (12) for supplying a projection beam of radiation;
a first object table (MT) for holding patterning means capable of patterning the projection beam according to a desired pattern;
a second object table (WT) for holding a substrate;
a reference frame (MF); and
a projection system (PL) for imaging irradiated portions of the mask onto target portions of the substrate; the method comprising the steps of:
providing a substrate provided with a radiation-sensitive layer to said second object table;
providing a projection beam of radiation using the illumination system;
using said patterning means to endow the projection beam with a pattern in its cross section; and
projecting the patterned beam onto said target portions of said substrate; **characterized in that**:
prior to or during said step of projecting, one of said object tables that is moveable relative to said reference frame is determined to be in a reference position by the steps of emitting radiation from a radiation source mounted on said reference frame toward a retro-reflector (13) mounted on said one object table, reflecting the radiation by said retro-reflector and detecting the reflected radiation in a radiation detector (15) mounted in a fixed position on said reference frame, wherein said radiation detector (15) is a two-dimensional radiation detector arranged to provide an output signal in each of two orthogonal directions as a function of the position of the reflected light beam on the detector.

12. A method according to claim 11, wherein said lithographic projection apparatus further comprises an incremental position sensing system for sensing the position of said one object table, said method comprising the further step, after said one object table is determined to be in said reference position, of determining the absolute position of said one object table by measuring movements thereof relative to said reference position using said incremental position sensing system.

## Patentansprüche

1. Lithographischer Apparat mit :
einem Beleuchtungssystem (12) zur Bereitstellung eines Projektionsstrahls der Strahlung ;
einem ersten Objekttisch (MT) zum Halten von Bemusterungsvorrichtungen, mit denen der Projektionsstrahl gemäß einem gewünschten Muster bemustert werden kann ;
einem zweiten Objekttisch (WT) zum Halten eines Substrats ;
einem Projektionssystem (PL) zum Abbilden bestrahlter Abschnitte der Maske auf Zielabschnitte des Substrats ;
einem Bezugsrahmen (MF) ; und
einer Positionsdetektionsvorrichtung mit :
einer Strahlungsquelle (11), die auf dem Bezugsrahmen (MF) montiert ist ;
einem Strahlungsdetektor (15), der in einer festen Position an dem Bezugsrahmen (MF) montiert ist ; und
einem Retro-Reflektor (13), der an einem der Objekttische (WT) montiert ist, und der in Bezug auf den Bezugsrahmen (MF) bewegt werden kann und derart angeordnet ist, dass er die Strahlung reflektiert, die von der Strahlungsquelle (11) zum Strahlungsdetektor (15) gesendet wird ; **dadurch gekennzeichnet, dass**
es sich bei dem Strahlungsdetektor (15) um einen zweidimensionalen Strahlungsdetektor handelt, der so angeordnet ist, dass er in Abhängigkeit von der Position des reflektierten Lichtstrahls auf den Detektor in jede der beiden orthogonalen Richtungen ein Ausgangssignal liefert.

2. Apparat nach Anspruch 1, wobei es sich bei der Strahlungsquelle (11) um eine Quelle kollimierter Strahlung handelt.

3. Apparat nach Anspruch 1 oder 2, wobei es sich bei der Strahlungsquelle (11) um eine Quelle monochromatischer Strahlung handelt.

4. Apparat nach einem der vorhergehenden Ansprüche, wobei die Strahlungsquelle (11) aus einer Lichtquelle (111) besteht, die von dem Bezugsrahmen (MF) entfernt montiert werden kann, aus Strahl-Lenkoptik (113) besteht, die auf dem Bezugsrahmen montiert wird, sowie aus einer optischen Faser (112) besteht, welche die Lichtquelle mit der Strahl-Lenkoptik verbindet.

5. Apparat nach einem der vorhergehenden Ansprüche, wobei die Strahlungsquelle (11) eine Laserdiode oder eine LED als Lichtquelle aufweist.

6. Apparat nach einem der vorhergehenden Ansprüche, wobei es sich bei dem zweidimensionalen Positionsdetektor (15) um eine zweidimensionale PSD-Kamera oder CCD-Kamera handelt oder um einen VierquadrantenPhotodetektor handelt.

7. Apparat nach einem der vorhergehenden Ansprüche, wobei der Retro-Reflektor (13) trapezförmig ist und für die Strahlung transparent ist und drei zueinander senkrecht verlaufende Flächen aufweist, die an einer Ecke aufeinandertreffen, wobei die drei Flächen einen reflektierenden Überzug aufweisen.

8. Apparat nach einem der Ansprüche 1 bis 6, wobei der Retro-Reflektor (13) eine konvergierende Linse und eine reflektierende Fläche aufweist, wobei die reflektierende Fläche einen Abstand zu der Linse hat, der der Brennweite der Linse entspricht.

9. Apparat nach einem der vorhergehenden Ansprüche mit drei Positionsdetektionsvorrichtungen, wie darin definiert.

10. Apparat nach einem der vorhergehenden Ansprüche, der weiterhin eine Inkremental-Positionsabtastvorrichtung zur Detektion der Position des beweglichen Objekttisches in einem Detektionsbereich besitzt, der breiter ist als der der Positionsdetektionsvorrichtung, sowie Einrichtungen zur Kombination der Ausgangssignale von der Inkremental-Positionsabtastvorrichtung und des Positionsdetektors, um eine absolute Position des Objekttisches in dem Detektionsbereich zu bestimmen.

11. Verfahren zur Herstellung einer Vorrichtung, die einen lithographischen Projektionsapparat verwendet, mit :
einem Beleuchtungssystem (12) zur Bereitstellung eines Projektionsstrahls der Strahlung ;
einem ersten Objekttisch (MT) zum Halten von Bemusterungsvorrichtungen, mit denen der Projektionsstrahl gemäß einem gewünschten Muster bemustert werden kann ;
einem zweiten Objekttisch (WT) zum Halten eines Substrats ;
einem Bezugsrahmen (MF) ; und
einem Projektionssystem (PL) zum Abbilden bestrahlter Abschnitte der Maske auf Zielabschnitte des Substrats ; wobei das Verfahren die folgenden Schritte aufweist :
Bereitstellen eines Substrats, das mit einer strahlungsempfindlichen Schicht auf dem zweiten Objekttisch versehen ist ;
Bereitstellen eines Projektionsstrahls der Strahlung unter Verwendung des Beleuchtungssystems ;
Verwenden der Bemusterungsvorrichtungen, um den Projektionsstrahl mit einem Muster in seinem Querschnitt zu versehen ; und
Projizieren des bemusterten Strahls auf den Zielabschnitt des Substrats; **dadurch gekennzeichnet, dass**
vor oder während des Schrittes des Projizierens festgelegt wird, dass sich einer der Objekttische, der in Bezug auf den Bezugsrahmen bewegt werden kann, in einer Bezugsposition befindet, und zwar durch die Schritte des Aussendens von Strahlung von einer Strahlungsquelle, die an dem Bezugsrahmen montiert ist, zu einem Retro-Reflektor (13), der an dem einen Objekttisch montiert ist, und die Strahlung durch den Retro-Reflektor reflektiert, und Detektion der reflektierten Strahlung in einem Strahlungsdetektor (15), der in einer festen Position an dem Bezugsrahmen montiert ist, wobei es sich bei dem Strahlungsdetektor (15) um einen zweidimensionalen Strahlungsdetektor handelt, der so angeordnet ist, dass er in Abhängigkeit von der Position des reflektierten Lichtstrahls auf den Detektor in jede der beiden orthogonalen Richtungen ein Ausgangssignal liefert.

12. Verfahren nach Anspruch 11, wobei der lithographische Projektionsapparat weiterhin ein Inkremental-Positions-Abtastsystem aufweist, um die Position des einen Objekttisches abzutasten, wobei das Verfahren - nachdem sich ein Objekttisch in der Bezugsposition befindet -weiterhin den Schritt aufweist, dass die absolute Position des einen Objekttisches bestimmt wird, indem dessen Bewegungen in Bezug auf die Bezugsposition unter Verwendung des Inkremental-Positions-Abtastsystems gemessen werden.

## Revendications

1. Appareil de projection lithographique comportant :
un système d'illumination (12) pour délivrer un faisceau de projection de rayonnement ;
une première table d'objet (MT) pour supporter des moyens de mise en forme capables de mettre en forme le faisceau de projection conformément à un motif voulu ;
une seconde table d'objet (WT) pour supporter un substrat ;
un système de projection (PL) pour reproduire des parties irradiées du masque sur des parties cibles du substrat ;
un cadre de référence (MF) ; et
un dispositif de détection de position comportant :
une source de rayonnement (11) montée sur ledit cadre de référence (MF) ;
un détecteur de rayonnement (15) monté à une position fixe sur ledit cadre de référence (MF) ; et
un rétro-réflecteur (13) monté sur une desdites tables d'objet (MT, WT) qui est mobile par rapport audit cadre de référence (MF) agencé pour réfléchir un rayonnement émis par ladite source de rayonnement (11) vers ledit détecteur de rayonnement (15) ; **caractérisé en ce que** :
ledit détecteur de rayonnement (15) est un détecteur de rayonnement bidimensionnel agencé pour délivrer un signal de sortie dans chaque direction parmi deux directions orthogonales en fonction de la position du faisceau lumineux réfléchi sur le détecteur.

2. Appareil selon la revendication 1, dans lequel ladite source de rayonnement (11) est une source de rayonnement collimaté.

3. Appareil selon la revendication 1 ou 2, dans lequel ladite source de rayonnement (11) est une source de rayonnement monochromatique.

4. Appareil selon l'une quelconque des revendications précédentes, dans lequel ladite source de rayonnement (11) comporte une source de lumière (111) pouvant être montée à distance du cadre de référence (MF), des optiques de direction de faisceau (113) montés sur ledit cadre de référence et une fibre optique (112) pour coupler ladite source de lumière auxdits optiques de direction de faisceau.

5. Appareil selon l'une quelconque des revendications précédentes, dans lequel ladite source de rayonnement (11) comporte une diode laser, ou une LED en tant que source de lumière.

6. Appareil selon l'une quelconque des revendications précédentes, dans lequel ledit détecteur de position bidimensionnel (15) est un PSD bidimensionnel, ou une caméra à CCD, ou un photodétecteur à quatre quadrants.

7. Appareil selon l'une quelconque des revendications précédentes, dans lequel ledit rétro-réflecteur (13) comporte une forme trapézoïdale d'un matériau transparent vis-à-vis dudit rayonnement et ayant trois surfaces mutuellement perpendiculaires se rejoignant à un coin, lesdites trois surfaces étant munies d'un revêtement réflecteur.

8. Appareil selon l'une quelconque des revendications 1 à 6, dans lequel ledit rétro-réflecteur (13) comporte une lentille convergente et une surface réflectrice, ladite surface réflectrice étant espacée par rapport à ladite lentille d'une distance égale à la longueur focale de ladite lentille.

9. Appareil selon l'une quelconque des revendications précédentes, comportant trois dispositifs de détection de position comme défini ici.

10. Appareil selon l'une quelconque des revendications précédentes, comportant de plus un dispositif de détection de position incrémentiel pour détecter la position de ladite table d'objet mobile dans une plage de détection plus large que celle dudit dispositif de détection de position et des moyens pour combiner des signaux de sortie provenant dudit dispositif de détection de position incrémentiel et dudit détecteur de position pour déterminer une position absolue de ladite table d'objet dans ladite plage de détection.

11. Procédé pour fabriquer un dispositif en utilisant un appareil de projection lithographique comportant :
un système d'illumination (12) pour délivrer un faisceau de projection de rayonnement ;
une première table d'objet (MT) pour supporter des moyens de mise en forme capables de mettre en forme le faisceau de projection conformément à un motif voulu ;
une seconde table d'objet (WT) pour supporter un substrat ;
un cadre de référence (MF) ; et
un système de projection (PL) pour reproduire des parties irradiées du masque sur des parties cibles du substrat ; le procédé comportant les étapes consistant à :
fournir un substrat muni d'une couche sensible au rayonnement sur ladite seconde table d'objet ;
délivrer un faisceau de projection de rayonnement en utilisant le système d'illumination ;
utiliser lesdits moyens de mise en forme pour doter le faisceau de projection d'un motif dans sa section transversale ; et
projeter le faisceau mis en forme sur lesdites parties cibles dudit substrat ; **caractérisé en ce que**
avant ou pendant l'étape de projection, une première desdites tables d'objet qui est mobile par rapport audit cadre de référence est déterminée comme étant à une position de référence par les étapes comportant l'émission d'un rayonnement depuis une source de rayonnement montée sur ledit cadre de référence en direction d'un rétro-réflecteur (13) monté sur ladite première table d'objet ; la réflexion du rayonnement par ledit rétro-réflecteur et la détection du rayonnement réfléchi dans un détecteur de rayonnement (15) monté à une position fixe sur ledit cadre de référence, dans lequel ledit détecteur de rayonnement (15) est un détecteur de rayonnement bidimensionnel conçu pour délivrer un signal de sortie dans chaque direction parmi deux directions orthogonales en fonction de la position du faisceau lumineux réfléchi sur le détecteur.

12. Procédé selon la revendication 11, dans lequel ledit appareil de projection lithographique comporte de plus un système de détection de position incrémentiel pour détecter la position de ladite première table d'objet, ledit procédé comportant l'étape supplémentaire, après avoir déterminé que ladite première table d'objet est à ladite position de référence, consistant à déterminer la position absolue de ladite première table d'objet en mesurant des mouvements de celle-ci par rapport à ladite position de référence en utilisant ledit système de détection de position incrémentiel.
